# EUROPEAN PATENT APPLICATION

(11) **EP 2 647 906 A2**
(43) Date of publication of application: **09.10.2013**
(21) Application number: 11845044.4
(22) Date of filing: 02.11.2011
(51) Int. Cl.: F21V 5/04, F21Y 101/02

(54) **WIDE ICICLE-TYPE LIGHT-ADJUSTING LENS FOR DIFFUSING THE LIGHT OF AN LED**

(30) Priority: 01.12.2010 KR 20100121273
(71) Applicant: Hyun, Dong Hoon, Siheung-si, Gyeonggi-do 429-752 (KR); Noh, Myeong-Jae, Uiwang-si, Gyeonggi-do 437-815 (KR)
(72) Inventor: Hyun, Dong Hoon, Siheung-si, Gyeonggi-do 429-752 (KR); Noh, Myeong-Jae, Uiwang-si, Gyeonggi-do 437-815 (KR)
(74) Representative: Grauel, Andreas
(86) International application number: PCT/KR2011/008286
(87) International publication number: WO 2012/074208

(57) **Abstract**

Disclosed is A light adjusting lens for adjusting light emitted from an LED, the light adjusting lens being a left-right symmetric lens structure formed of an amorphous polymer material selected from a glass material, PC, PMMA, and COC and having a body an entire interior of which is filled, the light adjusting lens including: an icicle inner surface forming an inner line of the body and having a light adjusting boss at a central portion thereof in the form in which a peak and a gully are formed deeply; and a light diffusing outer surface in which a light diffusion expanding induction for inducing expansion of diffusion of light is formed by slowly recessing the central portion of the aspheric structure, wherein diffusion of light is adjusted through dual processing of refraction and internal reflection by the icicle inner surface and the light diffusing outer surface.

## Description

### Technical Field

The present disclosure relates to a light adjusting lens for diffusing light generated by an LED. More particularly, embodiments of the present disclosure relate to a wide icicle type light adjusting lens for diffusing light of an LED which induces diffusion of light and uniformly controls diffused light such that the light has a uniform brightness through dual processing of internal reflection and refraction while minimizing glittering of the LED, and functions as a wide diffuser for diffusion of light which can be usefully utilized for the purpose of a park lamp for outdoor illumination or a backlight for an LED.

### Background Art

In recent years, LEDs are widely used as light sources in the entire industries including illumination apparatuses, and studies for efficiently using the LEDs are also actively made.

Meanwhile, light generated by an LED has straightness, and causes a glare phenomenon by glittering due to the optical characteristics in which light distributions are concentrated at a central portion of the LED rather than the peripheral portions thereof.

In order to supplement concentration of light distributions and glare, light diffusion adjusting lenses for adjusting light distributions of an LED have been developed to be coupled to the LED.

However, the conventional light diffusion adjusting lens for controlling light of an LED such that the light of the LED is diffused generates loss of light, fails to eliminate a glare phenomenon due to glittering, fails to induce a uniform brightness to deteriorate an overall light adjusting efficiency, and has a considerable difficulty in adjusting light emitted from the LED.

In particular, LEDs are used in various industrial fields such as indoor illuminations, outdoor illuminations, and backlights, in which case since a light adjusting lens is simply coupled in spite that stable optical characteristics are required due to adjustment of light distributions for purposes, development of industry cannot be expected and illumination efficiency suitable for in-use efficiency cannot be induced efficiently.

### Disclosure

### Technical Problem

Therefore, embodiments of the present invention have been made in view of the above-mentioned problems, and an aspect of the present invention is to provide a wide icicle type light adjusting lens for diffusing light of an LED which induces diffusion of light through dual processing of internal reflection and refraction and uniformly controls the diffused light such that the diffused light can have a uniform brightness while minimizing glittering of the LED, functions as a wide diffuser for diffusion of light to adjust distributions of light to form a wide angle of view (80 to 100 degrees) for the light emitted from the LED, thereby showing optical characteristics and stability by which the LED can be used for a park lamp of an outdoor illumination apparatus or a backlight.

In particular, another aspect of the present invention is to provide a wide icicle type light adjusting lens for diffusing light of an LED which adjusts diffusion of light to form a wide angle of view suitable for middle or long distance irradiation for light emitted from the LED and maintains uniformity of light as a whole, thereby maximizing an illumination efficiency of an outdoor illumination including a park lamp.

### Technical solution

In accordance with an aspect of the present invention, there is provided a light adjusting lens for adjusting light emitted from an LED, the light adjusting lens being a left-right symmetric lens structure formed of an amorphous polymer material selected from a glass material, PC, PMMA, and COC and having a body an entire interior of which is filled, the light adjusting lens including: an icicle inner surface forming an inner line of the body and having a light adjusting boss at a central portion thereof in the form in which a peak and a gully are formed deeply; and a light diffusing outer surface in which a light diffusion expanding induction for inducing expansion of diffusion of light is formed by slowly recessing the central portion of the aspheric structure, wherein diffusion of light is adjusted through dual processing of refraction and internal reflection by the icicle inner surface and the light diffusing outer surface.

An end of the light adjusting boss formed at a center of the icicle inner surface directly contacts an upper surface of an LED mounted to the lens structure or protrudes to be as close to the horizontal reference plane as possible.

The icicle inner surface and the light diffusing outer surface are aspheric.

### Advantageous Effects

The present invention provides a wide icicle type light adjusting lens for diffusing light of an LED which induces diffusion of light for light emitted from the LED through dual processing of internal reflection and refraction and uniformly controls the diffused light such that the diffused light can have a uniform brightness, and accordingly, functions as a wide diffuser for diffusion of light to adjust distributions of light to form a wide angle of view (80 to 100 degrees) for the light emitted from the LED, thereby showing optical characteristics and stability by which the LED can be used for a park lamp of an outdoor illumination apparatus or a backlight while minimizing glittering of the LED and thus preventing a glare phenomenon.

The present invention also provides a wide icicle type light adjusting lens for diffusing light of an LED which maintains uniformity of light as a whole to form a wide angle of view suitable for middle or long distance irradiation for light emitted from the LED and, thereby maximizing an illumination efficiency of an outdoor illumination including a park lamp and freely adjusting a light diffusion angle by using an aspheric surface.

### Brief Description of the Drawings

The foregoing and other objects, features and advantages of the present invention will become more apparent from the following detailed description when taken in conjunction with the accompanying drawings in which:

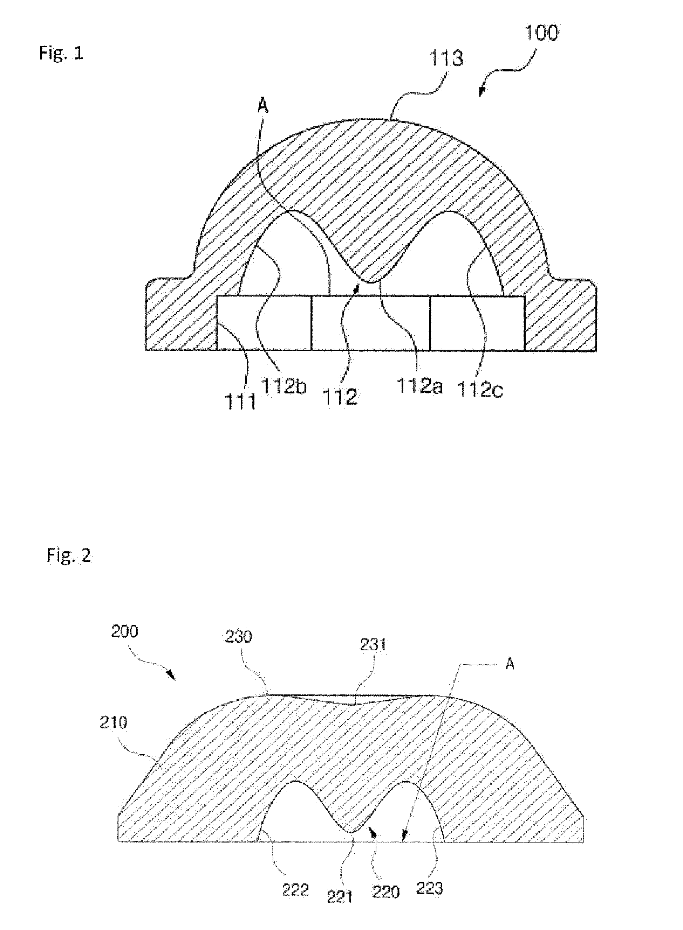

FIG. 1 is a sectional view showing an icicle type light adjusting lens for an LED illumination apparatus filed by the applicant which is not published yet;
FIG. 2 is a sectional view showing a wide icicle type light adjusting lens for diffusing light of an LED according to an embodiment of the present invention;

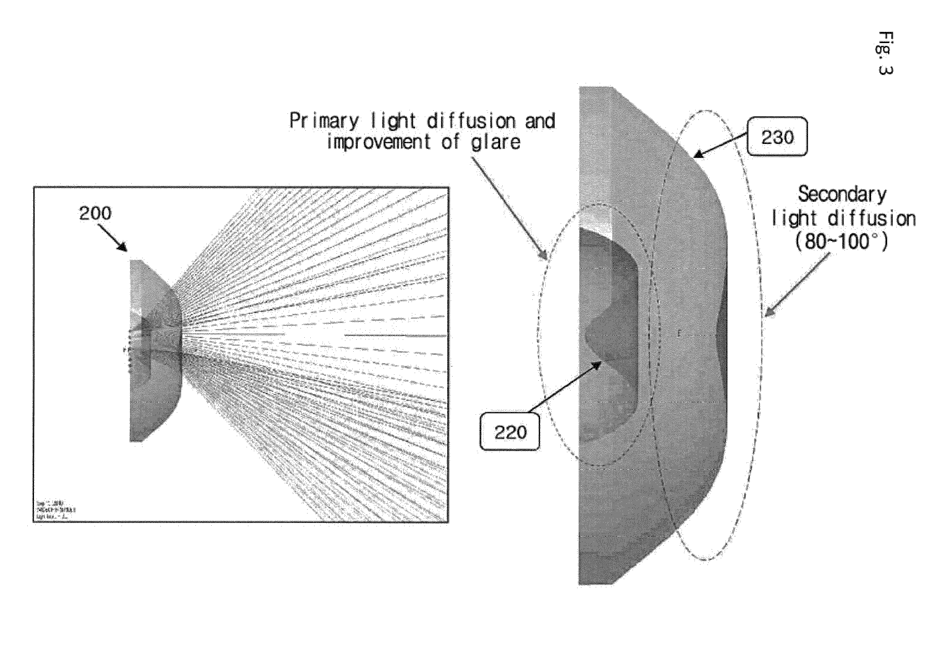

FIG. 3 is a view showing the wide icicle type light adjusting lens for diffusing light of an LED according to the embodiment of the present invention and a partial ray tracing diagram;

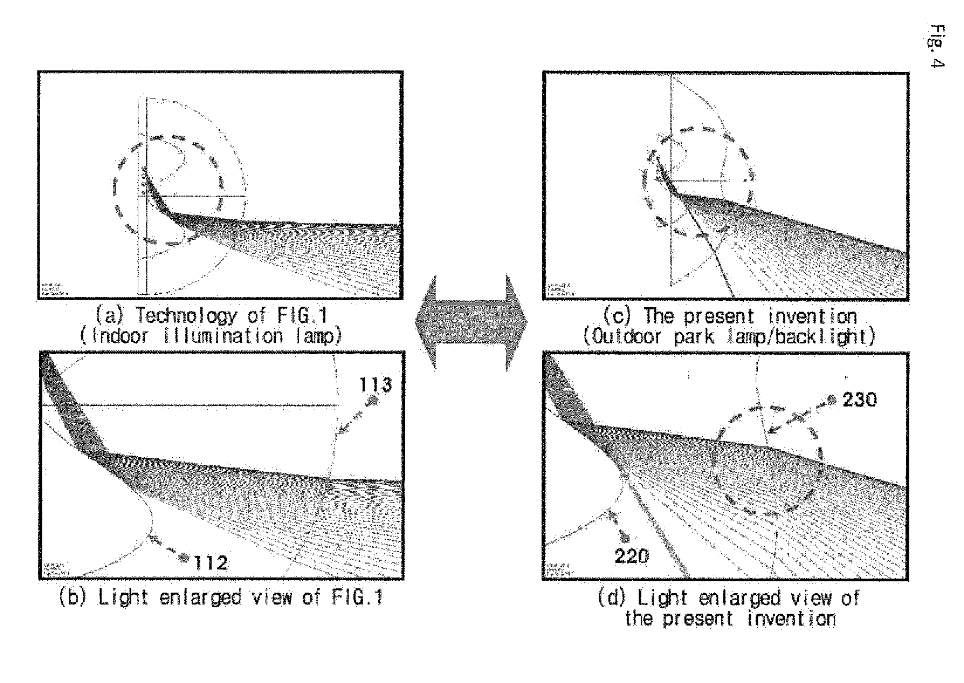

FIG. 4 shows ray tracing diagrams in the same field according to incidence of light emitted from an LED for comparing the present invention of FIG. 2 with the technology of FIG. 2, in which FIGS. 4A and 4B are ray tracing diagrams of the technology of FIG. 2 and FIGS. 4C and 4D are ray tracing diagrams of the wide icicle type light adjusting lens for diffusing light of an LED according to the embodiment of the present invention;

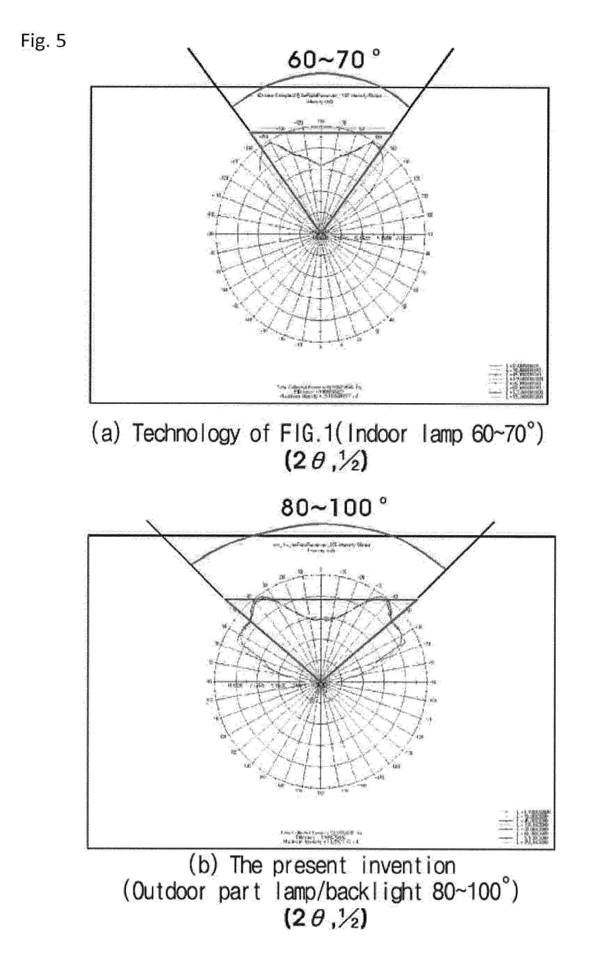

FIG. 5 shows radiation pattern graphs depicting light distribution curves in which light diffusion is adjusted according to the embodiment of the present invention of FIG. 2 and the technology of FIG. 1, in which FIG. 5A shows a radiation pattern according to the technology of FIG. 1 and FIG. 5B shows a radiation pattern according to the wide icicle type light adjusting lens for diffusing light of an LED according to the embodiment of the present invention;

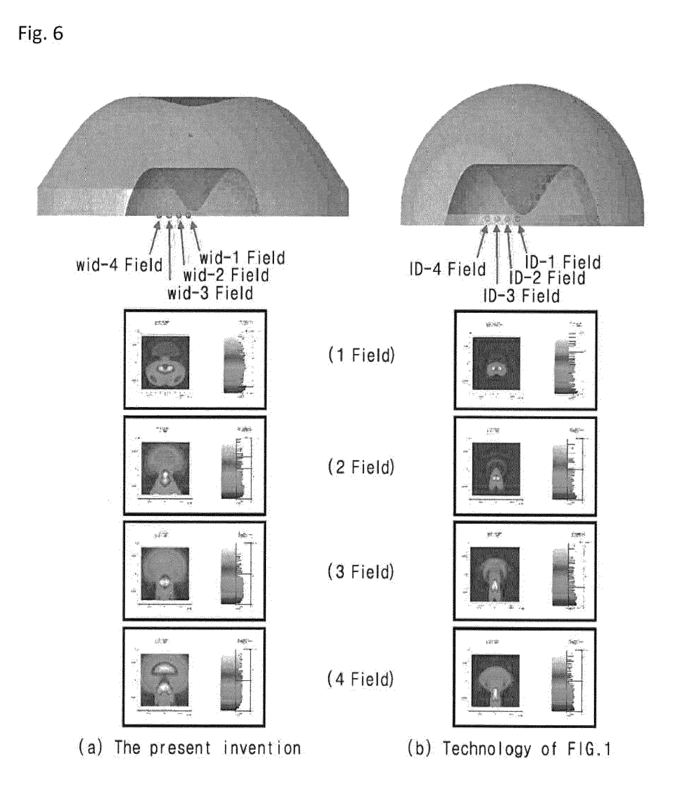

FIG. 6 shows illuminance raster charts depicting energy distributions for fields under the same condition according to the embodiment of the present invention of FIG. 2 and the technology of FIG. 1, in which FIG. 6A shows an illuminance raster chart according to the wide icicle type light adjusting lens for diffusing light of an LED according to the embodiment of the present invention and FIG. 6B is an illuminance raster chart according to the technology of FIG. 1;

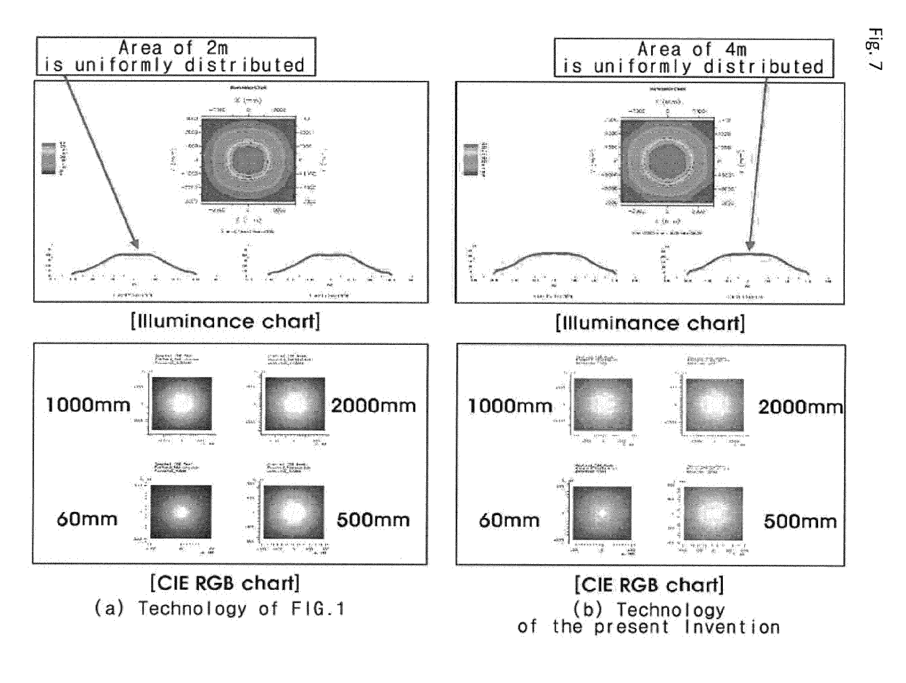

FIG. 7 shows data representing light distribution densities at which light is adjusted under the same condition according to the embodiment of the present invention of FIG. 2 and the technology of FIG. 1, and pattern stabilities, in which FIG. 7A shows simulation data according to the technology of FIG. 1 and FIG. 7B shows simulation data according to the embodiment of the present invention of FIG. 2 and the technology of FIG. 1; and

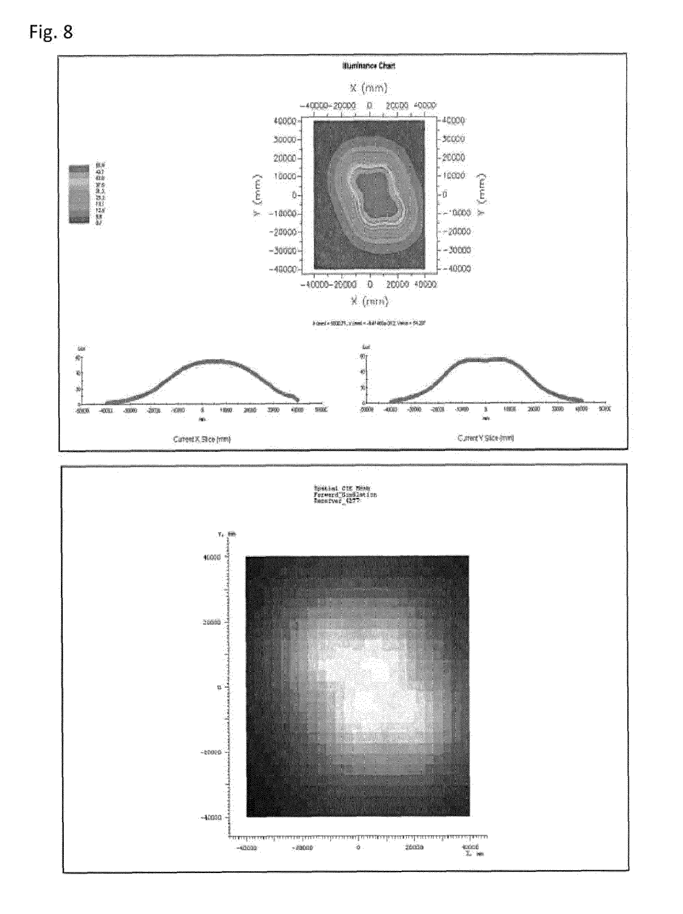

FIG. 8 shows views depicting an entire light density distribution when an LED is used as an outdoor park lamp to which the embodiment of the present is applied.

### Best Mode

### Mode for Invention

Hereinafter, an exemplary embodiment of the present invention will be described in detail with reference to the accompanying drawings. In the detailed description, the objects, configurations, and features of the present invention will be understood clearly.

A wide icicle type light adjusting lens 200 for diffusing light of an LED according to an embodiment of the present invention improves the technology of the icicle type light adjusting lens 100 for diffusing light having the structure of FIG. 1 [Configuration on Light Distribution Adjusting Technology Specified to Show Stable Optical Characteristics Suitable for Indoor Illumination Apparatus without Loss of Light for Light Emitted from LED], which was filed by the applicant and has not been published yet, to function as a park lamp of an outdoor illumination apparatus which forms a wider view of angle for light emitted from an LED and shows a stable illumination efficiency according to middle or long distance irradiation of 7 to 15 m or as a diffuser for a backlight of an LCD panel which maintains uniform brightness as a whole.

As shown in FIGS. 2 and 3, the wide icicle type light adjusting lens 200 for diffusing light of an LED according to the embodiment of the present invention is formed of a glass material or an amorphous polymer material, and includes a lens structure 210 having a body an entire interior of which is filled.

Then, the amorphous polymer material may be one selected from polycarbonate (PC), polymethylmethacrylate (PMMA), and cycloolenfincopolymer (COC).

The lens structure is left-right symmetrical, and includes an icicle inner surface 220 forming an inner line of the body and having an icicle type structure, and a light diffusing outer surface 230 forming an outer line of the body and having a dome type structure whose center is recessed.

The icicle inner surface 220 is aspheric, and has a form in which a peak and a gully are formed deeply so as to have a substantially M-shaped structure such as a light adjusting boss 221 like an icicle is formed at a central portion thereof.

The light diffusing outer surface 230 may be spherical or aspheric, and a light diffusion expanding induction portion 231 for inducing expansion of diffusion of light is formed by slowly recessing the central portion of the semispherical structure.

Then, although not shown, a recessed LED accommodating portion formed at a lower end in a normal direction along which light emitted from an LED to be used as a light source enters to be symmetrical with respect to a center thereof so as to accommodate the LED extends toward a lower side of the lens structure 210. The LED accommodating portion may have any structure if it can accommodate a chip type or light emitting diode type LED.

The icicle inner surface 220 of the lens structure 210 forms an inner surface of the lens structure. The icicle inner surface 220 of the lens structure 210 is a portion where light emitted from the LED starts to enter the lens structure 210 and a light distribution adjusting portion functioning as a diffused light unit for light emitted from the LED at the same time to minimize a glare phenomenon through a primary light diffusion. The icicle inner surface 220 of the lens structure 210 induces simultaneous operations of reflection and refraction for light emitted from the LED through the light adjusting boss 221 having the form of an icicle and refracts light emitted from the LED on left and right surfaces 222 and 223 having a concave surface in the direction of the LED except for the light adjusting boss 221 to uniformly diffuse light such that the light emitted from the LED functions as a surface light source.

Here, when an upper surface of the mounted LED mounted to the lens structure 210 is assumed to be a horizontal reference plane A, it is preferable that a downwardly protruding lengthwise end of the light adjusting boss 221 formed at a center of the icicle inner surface 220 directly contacts the horizontal reference plane A or is located to be as close to the horizontal reference plane A as possible.

That is, it is most preferable that an interval of 0 to 0.3 mm is disposed between the horizontal reference plane A and an end of the light adjusting boss 221 of the lens structure 210, which necessarily collides light emitted from a central portion of the LED with any one point of the light adjusting boss 221 to induce reflection and refraction, thereby increasing a light distributions adjusting efficiency and inducing a uniform brightness through this.

Further, as the icicle inner surface 220 is formed to be aspheric, a shape of the icicle inner surface 220 such as a deflection angle can be easily changed, making it possible to freely adjust distribution of light emitted from the LED.

The light diffusing outer surface 230 of the lens structure 210 forms an outer surface of the lens structure. The light diffusing outer surface 230 of the lens structure 210 functions to primarily diffuse light through the icicle inner surface 220 and secondarily diffuse light emitted from the LED, which has been adjusted, through internal reflection and refraction, thereby widening an angle of view as compared with the primary light diffusion. The light diffusing outer surface 230 of the lens structure 210 induces uniform surface light source distribution in a wider area to achieve a linear light distribution.

Then, it is more preferable that the light diffusing outer surface 230 is aspheric rather than spherical. A shape of the light diffusing outer surface 230 such as a deflection angle can be easily changed through the aspheric surface and light distribution of light emitted from the LED can be freely adjusted.

The wide icicle type light adjusting lens 200 for diffusing light of an LED according to the embodiment of the present invention diffuses and adjusts distribution of light emitted from the LED, which is a light source, to extremely minimize a glare phenomenon while achieving a surface light source instead of a point light source and inducing diffusion of light through dual processing of internal reflection and refraction. Through this, the wide icicle type light adjusting lens 200 for diffusing light of an LED according to the embodiment of the present invention can widen an angle of view to a wider area and maintain uniformity of light whose distribution is adjusted, thereby functioning as a light adjusting unit having a uniform brightness and also properly functioning as an outdoor illumination or a backlight.

Meanwhile, Table 1 represents aspheric data of the wide icicle type light adjusting lens 200 according to the embodiment of the present invention. To help understanding of the aspheric data, the shape of the light adjusting lens 200 is schematically shown together with the aspheric data and both the icicle inner surface 220 and the light diffusing outer surface 230 are aspheric.

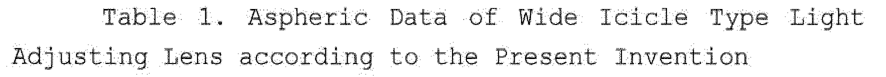

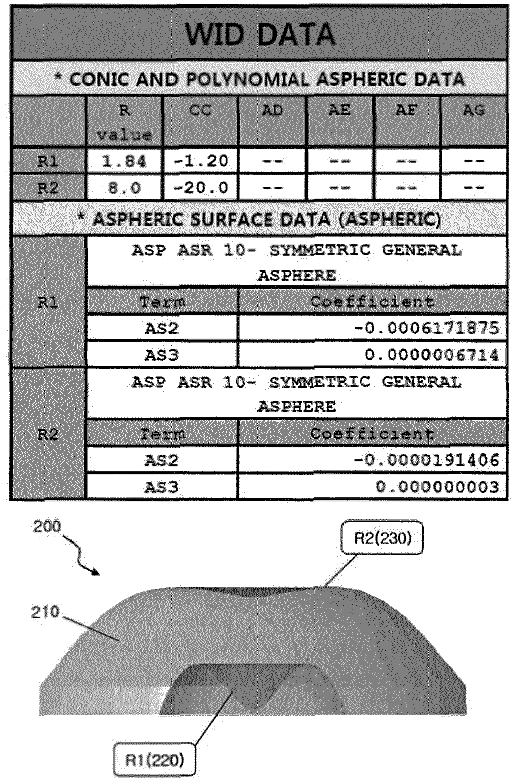

Here, Table 1 shows that R1 and R2 corresponding to the icicle inner surface 220 and the light diffusing outer surface 230 have aspheric conic constant and aspheric surface coefficients as well as aspheric curvature values.

Accordingly, it can be seen that radiation paths and light distributions of the light emitted from an LED can be freely adjusted by adjusting the aspheric conic constants and aspheric coefficients of the icicle inner surface 220 and the light diffusing outer surface 230.

Meanwhile, FIG. 4 shows ray tracing diagrams in the same field according to incidence of light emitted from an LED for comparing the present invention of FIG. 2 with the technology of FIG. 2, in which FIGS. 4A and 4B are ray tracing diagrams of the technology of FIG. 1 and FIGS. 4C and 4D are ray tracing diagrams of the wide icicle type light adjusting lens for diffusing light of an LED according to the embodiment of the present invention.

Here, as can be seen from FIGS. 4C and 4D, the light diffusing outer surface of the present invention further expands diffusion of light outward as compared with the outer surface 113 of FIG. 1 and a uniform surface light distribution is possible in a wider area for diffusion of light.

FIG. 5 shows radiation pattern graphs depicting light distribution curves in which light diffusion is adjusted according to the embodiment of the present invention of FIG. 2 and the technology of FIG. 1, in which FIG. 5A shows a radiation pattern according to the technology of FIG. 1 and FIG. 5B shows a radiation pattern according to the wide icicle type light adjusting lens for diffusing light of an LED according to the embodiment of the present invention.

Here, it can be seen that the radiation pattern of FIG. 5B according to the present invention is distributed wider than the radiation pattern of FIG. 5A according to the technology of FIG. 1. As can be seen from the light distribution angles through the radiation patterns, the technology according to the present invention can further induce light diffusion at an angle of view of 80 to 100 degrees according to dual processing of internal reflection and refraction as compared with the technology of FIG. 1.

FIG. 6 shows illuminance raster charts depicting energy distributions for fields under the same condition according to the embodiment of the present invention of FIG. 2 and the technology of FIG. 1, in which FIG. 6A shows an illuminance raster chart according to the wide icicle type light adjusting lens for diffusing light of an LED according to the embodiment of the present invention and FIG. 6B is an illuminance raster chart according to the technology of FIG. 1.

As can be seen from FIG. 6A according to the present invention, light is controlled for respective fields and data of the fields overlap each other, improving uniformity of light as compared with FIG. 6B. Further, FIG. 6B shows a diffusion light unit suitable for an indoor illumination lamp, whereas FIG. 6A according to the present invention shows that light is uniformly adjusted by a light expansion unit for diffusing light which can maximally induce efficiency as an outdoor illumination or a backlight for light emitted from an LED.

FIG. 7 shows data representing light distribution densities at which light is adjusted under the same condition according to the embodiment of the present invention of FIG. 2 and the technology of FIG. 1, and pattern stabilities, in which FIG. 7A shows simulation data according to the technology of FIG. 1 and FIG. 7B shows simulation data according to the embodiment of the present invention of FIG. 2 and the technology of FIG. 1.

Here, when the upper light distribution densities are reviewed, both have surface light radiation forms. However, the light distributions densities of FIG. 7B located on the right side forms a surface light radiation form in a wider area on both X-axis line and Y-axis line without a central concentration phenomenon as compared with the technology of FIG. 1A. Thus, the present invention functions as an expansion unit for diffusing light more suitable for an outdoor illumination or an illumination of a backlight.

The lower sides of FIGS. 7A and 7B show data obtained by simulating stabilities of light distribution patterns according to changes in distances such 60 mm, 500 mm, 1000 mm, and 2000 mm. When the pattern stabilities according to the changes in distances for an actual examination are compared, the data of FIG. 7B according to the present invention are distributed in a wide area and adjust light very stably and in the same pattern as compared with the data of FIG. 7A according the technology of FIG. 1. Thus, it can be seen that uniformity becomes more excellent as the distance increases.

FIG. 8 shows views depicting an entire light density distribution when an LED is used as an outdoor park lamp to which the embodiment of the present is applied. When the lamps are installed at a height of 10 m and the uniform interval is 20 mm transversely and longitudinally, the reception area becomes 80 m X 80 m and the efficiency of the reception area is 99%, showing a light uniformity of 40 m.

Further, when the light distribution density on the X-axis of the upper left side and the light distribution density on the Y-axis of the right side are reviewed, it can be seen that light diffusion and light uniformity can be realized over a wide range.

## Claims

1. A light adjusting lens for adjusting light emitted from an LED, the light adjusting lens being a left-right symmetric lens structure formed of an amorphous polymer material selected from a glass material, PC, PMMA, and COC and having a body an entire interior of which is filled, the light adjusting lens comprising:
an icicle inner surface forming an inner line of the body and having a light adjusting boss at a central portion thereof in the form in which a peak and a gully are formed deeply; and
a light diffusing outer surface in which a light diffusion expanding induction for inducing expansion of diffusion of light is formed by slowly recessing the central portion of the aspheric structure,
wherein diffusion of light is adjusted through dual processing of refraction and internal reflection by the icicle inner surface and the light diffusing outer surface.

2. The light adjusting lens as claimed in claim 1, wherein in the lens structure, an end of the light adjusting boss formed at a center of the icicle inner surface directly contacts an upper surface of an LED mounted to the lens structure or protrudes to be as close to the horizontal reference plane as possible.

3. The light adjusting lens as claimed in claim 1, wherein the icicle inner surface and the light diffusing outer surface are aspheric.
